# EUROPEAN PATENT SPECIFICATION

(11) **EP 3 787 385 B1**
(45) Date of publication and mention of the grant of the patent: **23.03.2022**
(21) Application number: 19315103.2
(22) Date of filing: 26.08.2019
(51) Int. Cl.: H05K 7/20

(54) **COOLING ARRANGEMENT FOR A RACK HOSTING ELECTRONIC EQUIPMENT AND AT LEAST ONE FAN**
KÜHLANORDNUNG FÜR EIN RACK MIT ELEKTRONISCHER AUSRÜSTUNG UND MINDESTENS EINEM GEBLÄSE
AGENCEMENT DE REFROIDISSEMENT POUR UNE BAIE HÉBERGEANT UN ÉQUIPEMENT ÉLECTRONIQUE ET AU MOINS UN VENTILATEUR

(43) Date of publication of application: 03.03.2021
(73) Proprietor: OVH, 59100 Roubaix (FR)
(72) Inventor: Chehade, Ali, 59242 Templeuve (FR); Bauduin, Hadrien, 59650 Villeneuve d'Ascq (FR); Klaba, Henryk, 59100 Roubaix (FR)
(74) Representative: BCF Global

(56) References cited:
- CN-A- 108 323 124
- CN-B- 106 385 784
- US-A1- 2009 262 501
- US-A1- 2012 279 684
- US-A1- 2013 118 712

## Description

### FIELD

The present technology relates to cooling techniques for electronic equipment. In particular, a cooling arrangement for a rack hosting electronic equipment and at least one fan is disclosed.

### BACKGROUND

Electronic equipment, for example servers, memory banks, computer discs, and the like, is conventionally grouped in equipment racks. Large data centers that may contain thousands of racks supporting thousands or even tens of thousands of servers.

The racks, including equipment mounted in their backplanes, consume large amounts of electric power and generate significant amounts of heat. Cooling needs are important in such racks. Some electronic devices, such as processors, generate so much heat that they could fail within seconds in case of a lack of cooling.

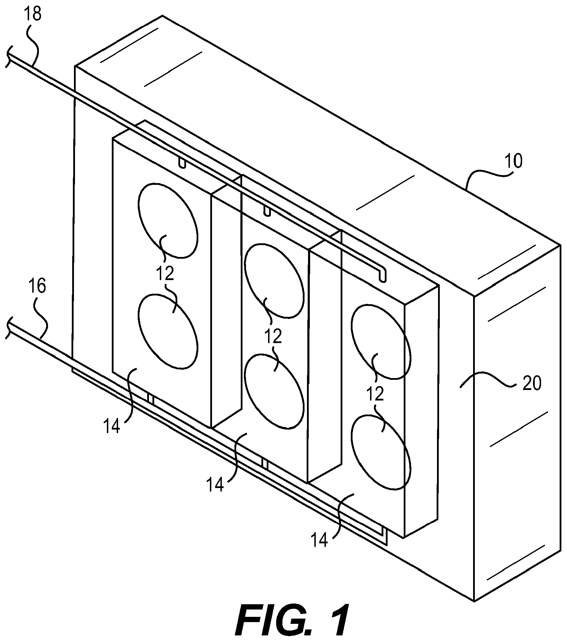

Fans are commonly mounted within equipment racks to provide forced ventilation cooling to rack-mounted equipment. This solution merely displaces some of the heat generated within the racks to the general environment of the data center. Air-liquid heat exchangers, finned tubes heat exchangers similar to radiators, may be mounted to the racks to absorb and transport some of this displaced heat to further cooling equipment, for example cooling towers, located outside of the data center. For example, Figure 1 is a highly schematic perspective view of a server rack on which three (3) air-liquid heat exchangers are mounted. A server rack 10 hosts a number of servers (not shown) that generate a significant amount of heat. A number of fans 12 (six fans are shown without limiting the present disclosure) expel heated air from the server rack 10 in a direction of three (3) air-liquid heat exchangers 14 mounted behind a backplane 20 of the server rack 10. On Figure 1, the air-liquid heat exchangers 14 are shown in transparent form in order to render the fans 12 visible. The air-liquid heat exchangers 14 receive cold liquid, for example water, from a cold liquid line 16 and return heated liquid to a hot liquid line 18. The airflow having passed through the air-liquid heat exchangers 14 is somewhat cooled down to allow maintaining an ambient temperature of the data center to a reasonable level.

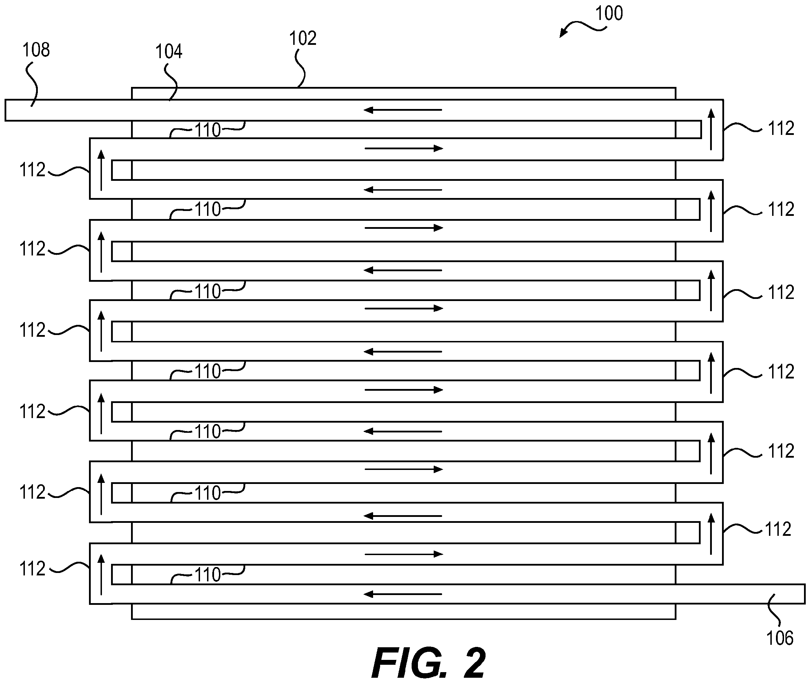

Figure 2 is a schematic diagram of a single-flow air-liquid heat exchanger. A single-flow heat exchanger 100 comprises a frame 102 and a continuous internal conduit 104. The continuous internal conduit 104 is connected at one end to liquid inlet 106 and at an opposite end to a liquid outlet 108. The liquid inlet 106 is connectable to a supply line such as the cold liquid line 16 for receiving a cold liquid, for example water. The liquid outlet 108 is connectable to a return line such as the hot liquid line 18 for returning the liquid that, in operation, has absorbed heat from an airflow passing through the frame 102. The continuous internal conduit 104 forms a plurality of interconnected parallel sections 110 that extend within the frame 102.

The liquid inlet 106 is connected to a first interconnected parallel section 110. Each interconnected parallel section 110, except a last one, is connected to a next interconnected parallel section 110 via a generally U-shaped section 112 of the continuous internal conduit 104. The last interconnected parallel section 110 is connected to the liquid outlet 108. Liquid received at the liquid inlet 106 flows within the continuous internal conduit 104 in the direction shown by the various arrows until it reaches the liquid outlet 108. Heat from the air flowing through the frame 102 of the air-liquid heat exchanger 100 is absorbed at least in part by the liquid flowing through the continuous internal conduit 104.

The single-flow heat exchanger 100 is thin, especially when compared to a thickness of the server rack 10. Given its thinness, the single-flow heat exchanger 100 adds little to the overall space occupancy of the server rack 10 in the data center. The thinness of the single-flow heat exchanger 100 further allows its mounting on the server rack 10 by use of hinges (not shown) so that the single-flow heat exchanger 100 may be moved aside, as when opening a door, to provide access to components present in the backplane 20 of the rack 10.

The frame 102 occupies most of the overall width of single-flow heat exchanger 100, as only the generally U-shaped section 112 of the continuous internal conduit 104 protrude on each side of the frame 102. Consequently, the single-flow heat exchanger 100 offers a broad surface that may be traversed by a flow of air expelled from the server rack 10.

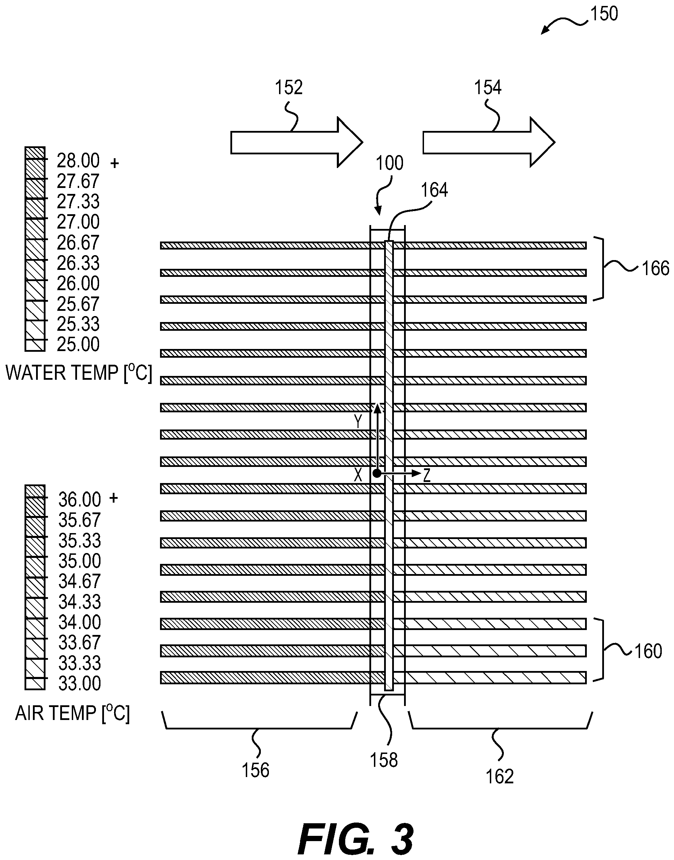

Figure 3 is a visual representation of a stratified temperature pattern of an airflow expelled from the single-flow air-liquid heat exchanger of Figure 2. A diagram 150 illustrates a temperature of a flow of air measured in an experimental setup, before and after passing through the single-flow heat exchanger 100. The air flows in the direction of arrows 152 and 154. In a first zone 156 upstream of the air-liquid heat exchanger 100, a temperature of the airflow is high due to the generation of heat in the server rack 10, being for example at about 40 degrees. The temperature of the airflow is substantially uniform within the first zone 156. Cold water is received at the bottom 158 of the single-flow heat exchanger 100, at a temperature of about 25 degrees. Lower strata 160 of the air flowing in a zone 162 downstream of the single-flow heat exchanger 100 are cooled to about 33 degrees. A temperature of the water flowing through the single-flow heat exchanger 100 increases as it passes through the various interconnected parallel sections 110, being continuously exposed to the 40 degrees airflow. The water reaches about 28 degrees the top 164 of the single-flow heat exchanger 100. Consequently, a topmost section of the single-flow heat exchanger 100 is less efficient in cooling the flow of air in upper strata 166, which are only cooled to about 36 degrees.

This lack of homogeneity of the flow of air expelled from the single-flow heat exchanger 100 causes a plurality of problems.

One problem is that it becomes difficult to place a plurality of server racks 10 in close proximity to one another because the air expelled from a first server rack 10 and aspired by the fans 12 of a second, proximally located server rack 10, is not suitable for efficiently cooling of that second server rack 10. This is particularly the case when it is desired to place a plurality of server racks 12 in front of one another, with the same orientation.

Another problem relates to the monitoring of cooling efficiency. Such monitoring is important as safety measures may need to be applied without delay in case of cooling failure. In the data center, temperature sensors (not shown) are positioned in various places on the server racks 10. When such temperature sensors are mounted on the single-flow heat exchangers 100, slight variations in the placement of these temperatures sensors on the surface of each single-flow heat exchanger 100 may lead to imprecisions that are detrimental to the overall monitoring of the cooling performance. For example when the interconnected parallel sections 110 extend horizontally, as illustrated on Figure 2, positioning a temperature sensor at different heights on various single-flow heat exchanger 100 may cause to acquire inconsistent measurements.

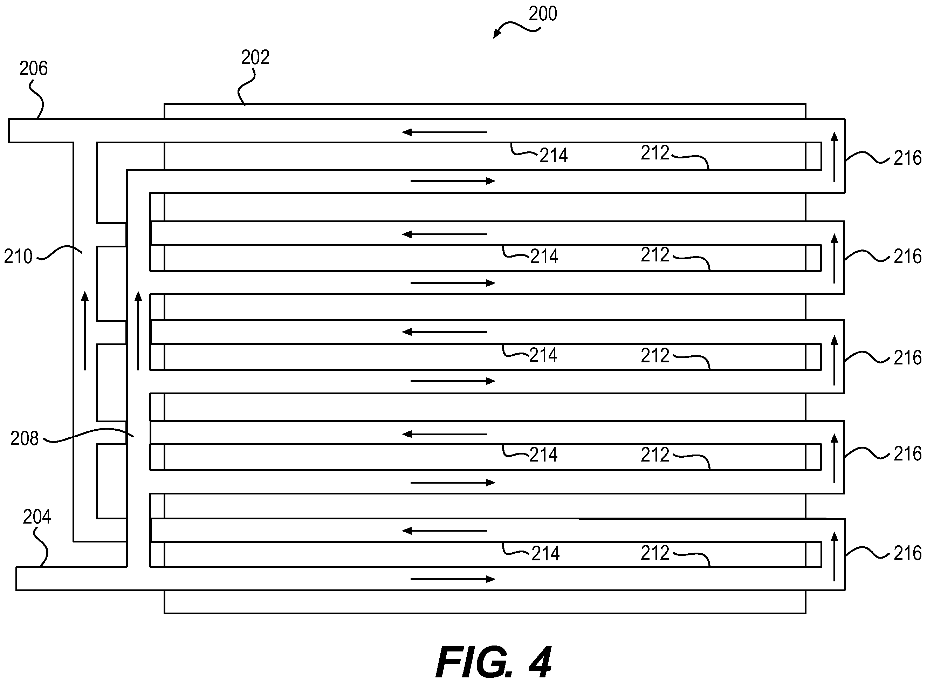

Figure 4 is a schematic diagram of a multi-flow air-liquid heat exchanger. A multi-flow air-liquid heat exchanger 200 comprises a frame 202, a liquid inlet 204 and a liquid outlet 206. The liquid inlet 204 is connected to a first manifold 208 and the liquid outlet 206 is connected to a second manifold 210. The first and second manifolds 208 and 210 are sometimes collectively called a "nurse" because the first manifold 208 feeds a cold liquid received at the liquid inlet 204 to a first plurality of parallel internal conduits 212, each of which is connected to one of a second plurality of parallel internal conduits 214 via a respective U-shaped link 216, the parallel internal conduits 214 being connected to the liquid outlet 206 via the second manifold 210. The first and second manifolds 208 and 210 as illustrated are located outside of the frame 202 and are positioned in an area where an airflow from the server rack 10 is substantially blocked. The first and second manifolds 208 and 210 usually have a diameter that is significantly larger than a diameter of the parallel internal conduits 212 and 214 in order for each of the parallel internal conduits 212 and 214 to be fed with substantially equal liquid flows.

When compared to the single-flow heat exchanger 100, multi-flow air-liquid heat exchanger 200 is much less subject to cause a temperature stratification of air flowing therethrough. The multi-flow air-liquid heat exchanger 200 however brings other disadvantages.

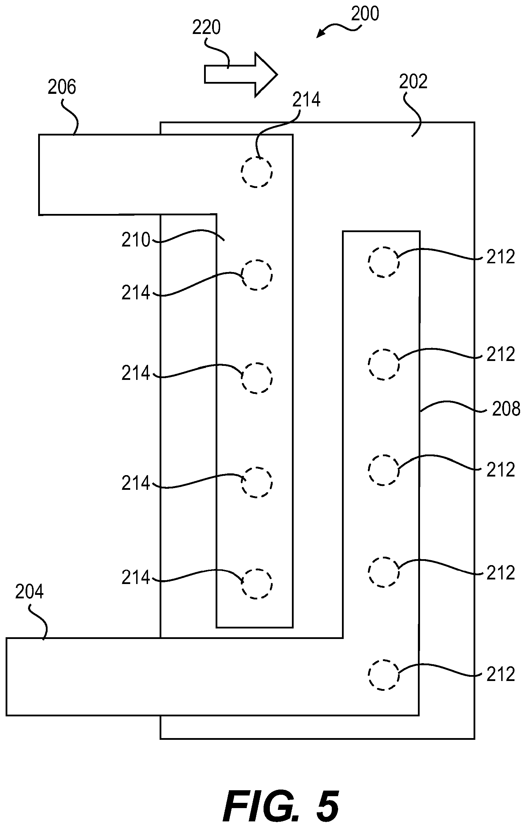

Figure 5 is a schematic side-view of the multi-flow air-liquid heat exchanger of Figure 4. On Figure 5, the air expelled from the server rack 10 flows in a direction of the arrow 220. The frame 202 has an important thickness due to the presence of the first and second manifolds 208 and 210. This thickness may become problematic when mounting a large number of multi-flow air-liquid heat exchangers 200 on a respectively large number of server racks 10 in the data center. A same number of server racks 10 will occupy more of the floor space of the data center. It may be noted that the multi-flow air-liquid heat exchanger as illustrated on Figures 4 and 5 is only a simple example of many possible configurations.

Another disadvantage of the multi-flow air-liquid heat exchanger 200, which is also caused by its thickness, is that it cannot conveniently be mounted on the server rack 10 by use of hinges. The multi-flow air-liquid heat exchanger 200 needs to be fully dismounted from the server rack 10 to provide access to the backplane 20.

A further disadvantage of the multi-flow air-liquid heat exchanger 200 relates to its geometry. The nurse formed by the first and second manifolds 208 and 210 occupies a significant share of the overall surface of the multi-flow air-liquid heat exchanger 200, leaving a lesser share of this overall surface that be traversed by a flow of air expelled from the server rack 10, when compared with the single-flow heat exchanger 100.

In addition to the above-mentioned concerns, other concerns relate to the potential failure of cooling equipment, for example due to blockage of liquid conduits. The single-flow heat exchanger 100 and multi-flow air-liquid heat exchanger 200 each have a single inlet 106 or 204 and a single outlet 108 or 206, so any blockage of at the level of these inlets and outlets may lead to a complete loss of cooling of the airflow expelled from the server rack 10.

Even though the recent developments identified above may provide benefits, improvements are still desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

US 2012/0279684 A1 describes a system for cooling electronic equipment. The system includes first and second heat exchangers and a condenser. The first exchanger is disposed in an airflow in thermal communication with electronic equipment and receives a cooling fluid at a first temperature. The first exchanger enables heat transfer from the airflow to the cooling fluid to heat the cooling fluid to a second temperature. The second exchanger is disposed in the airflow between the first exchanger and the electronic equipment and receives the cooling fluid at the second temperature. The second exchanger enables heat transfer from the airflow to the cooling fluid to heat the cooling fluid to a third temperature. The condenser receives the cooling fluid at the third temperature and enables heat transfer from the cooling fluid to a cooling source to cool the cooling fluid to the first temperature.

CN 106 385 784 B describes determining an angle of an air flow guide blade, an angle of an air-to-liquid heat exchanger, and a vertical point return air temperature of a machine cabinet server. A rotating speed of a fan is detected to increase an air flow. A machine cabinet server input current is reduced bv a cooling cabinet. The air flow guide blade is rotated based on the angle of the machine cabinet server along an air flow inlet direction to increase the air flow at an inlet of the machine cabinet server. A flow rate of a cooling liquid in an air-to-liquid heat exchange module is also adjusted.

US 2013/0118712 A1 describes an apparatus, a rear door heat exchanger, a system, and a method for controlling the redundancy of a cooling system for a server rack. The system includes a cooling system having at least two liquid cooling circuits. The system also includes a rear door heat exchanger connected to the cooling system. The rear door heat exchanger includes two heat exchange coils. Each heat exchange coil is carried by the server rack and interfaced with a different liquid cooling circuit. The rear door heat exchanger also includes an adapter coupling together the two heat exchange coils into one heat exchange unit. The heat exchange unit interfaces with one liquid cooling circuit from the cooling system.

US 2009/0262501 A1 describes rack assemblies and methods for cooling one or more rack-based computer systems, as well as data center configurations that utilize the rack assembly. The rack assembly comprises a rack providing support for multiple columns of heat-generating electronic devices and device fans for moving air from an air inlet side of the rack through the devices and through an air outlet side of the rack. The rack assembly also comprises a unitary door having a support frame spanning the air outlet side of the rack and hingedly coupling the door to a rear vertical edge of the rack. The door includes an air-to-liquid heat exchanger panel spanning an air outlet passage inside the support frame so that substantially all of the air passing through the air outlet must pass through the heat exchanger panel. The air outlet passage has a cross-sectional area that is substantially equal to or greater than the cross-sectional area of the multiple columns of heat-generating devices.

CN 108 323 124 A describes a cabinet having an electronic device connected with a machine cabinet main body. A tray is connected with the electronic device along parallel direction. A wire arranging frame is connected with a side of the cabinet main body. The electronic device is formed with multiple U-shaped grooves for moving a cable. A cooling equipment cabinet body is connected with a cooling device. A heat exchanger and a fan assembly are connected with the cooling equipment cabinet body. The cooling equipment cabinet body is fixed with a rear plate. The cabinet main body is provided with a radiating window for ventilating and radiating heat. A fan is fixed on the rear plate. An end of the heat exchanger is fixed on a rear part of an electronic equipment rack. The cooling equipment cabinet body performs high-temperature air cooling process and discharges the air into an environment fan group.

### SUMMARY

Embodiments of the present technology have been developed based on developers' appreciation of shortcomings associated with the prior art.

In particular, such shortcomings may comprise (1) lack of homogeneity of the flow of air expelled from a single-flow heat exchanger 100; (2) space occupancy of cooling equipment; and/or (3) potential failure of cooling equipment. The object of the invention is solved by a cooling arrangement according to claim 1. Preferred embodiments are presented in the dependent claims.

In the context of the present specification, unless expressly provided otherwise, electronic equipment may refer, but is not limited to, "servers", "electronic devices", "operation systems", "systems", "computer-based systems", "controller units", "monitoring devices", a "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a highly schematic perspective view of a server rack on which three (3) air-liquid heat exchangers are mounted;
Figure 2 is a schematic diagram of a single-flow air-liquid heat exchanger;
Figure 3 is a visual representation of a stratified temperature pattern of an airflow expelled from the single-flow air-liquid heat exchanger of Figure 2;
Figure 4 is a schematic diagram of a multi-flow air-liquid heat exchanger;
Figure 5 is a schematic side-view of the multi-flow air-liquid heat exchanger of Figure 4;
Figure 6 is a highly schematic representation of a pair of air-liquid heat exchangers assembled in an anti-parallel configuration in accordance with an embodiment of the present technology;
Figure 7 is a perspective view of a server rack on which pairs of dual-flow air-liquid heat exchangers are mounted in an anti-parallel configuration in accordance with an embodiment of the present technology;
Figure 8 is a side elevation view of the server rack of Figure 7 in accordance with an embodiment of the present technology; and
Figure 9 is a visual representation of a homogeneous temperature pattern of an airflow expelled from dual-flow air-liquid heat exchangers assembled in an anti-parallel configuration in accordance with an embodiment of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

In an aspect, the present technology reduces or eliminates the problems related to the stratification of the airflow temperature expelled from air-liquid heat exchangers. Two (2) equivalent air-liquid heat exchangers are mounted in series on a rack so that air expelled from the rack by fans mounted within the rack flow through both air-liquid heat exchangers. The air-liquid heat exchangers are mounted in anti-parallel fashion. For instance, a cold liquid such as water is fed to a first air-liquid heat exchanger though a top-mounted inlet and flows through horizontal parallel conduits until it reaches a bottom-mounted outlet. Air expelled from the rack and flowing through the first air-liquid heat exchanger does have a stratified temperature pattern. However, the same air flows through a second air-liquid heat exchanger having an anti-parallel stance from the first air-liquid heat exchanger. Cold water or another cooling liquid is fed to a bottom-mounted inlet of this second air-liquid heat exchanger and flows through horizontal parallel conduits until it reaches a top-mounted outlet. In this way, hotter air strata expelled from the first air-liquid heat exchanger are exposed to those of the horizontal parallel conduits of the second air-liquid heat exchanger that are closest to the bottom-mounted inlet. Airflow expelled from the second air-liquid heat exchanger thus has a substantially homogeneous temperature pattern. A combination of the two air-liquid heat exchangers has a thickness as measured along the path of the airflow that is less than that of a conventional multi-flow air-liquid heat exchanger, as illustrated on Figures 4 and 5, this combination also providing a broader surface adapted for being traversed by the airflow, when compared with the conventional multi-flow air-liquid heat exchanger.

With these fundamentals in place, we will now consider some non-limiting examples to illustrate various implementations of aspects of the present technology.

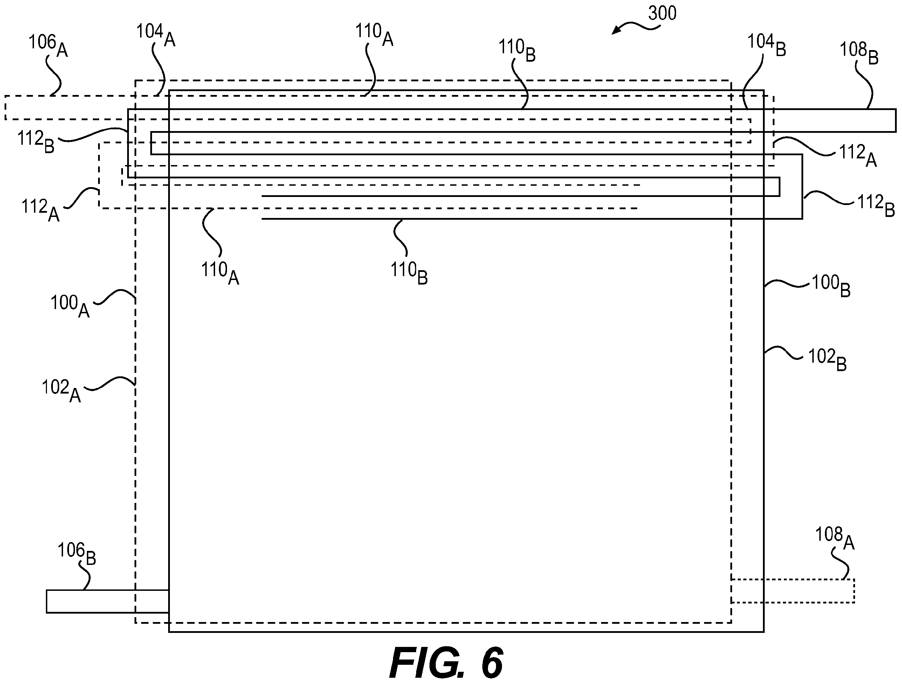

Figure 6 is a highly schematic representation of a pair of air-liquid heat exchangers assembled in an anti-parallel configuration in accordance with an embodiment of the present technology. A cooling arrangement 300 that may be mounted on a rack hosting electronic equipment and at least one fan, for example the server rack 10 having the fans 12, comprises at least a pair of air-liquid heat exchangers, for example and without limitation, a pair of single-flow heat exchangers 100 as introduced in the description of Figure 2. With continued reference to Figure 6, also considering Figures 1 and 2, a first air-liquid heat exchanger 100_{A} is shown in dotted lines and a second air-liquid heat exchanger 100_{B} is shown in solid lines. On Figure 6, the first and second air-liquid heat exchangers 100_{A} and 100_{B} are shown as being mounted at an offset from one another; this illustration is solely intended to render visible various parts of the first and second air-liquid heat exchangers 100_{A} and 100_{B}. In a practical application, the first and second air-liquid heat exchangers 100_{A} and 100_{B} may be aligned so that there is no discernable offset therebetween.

The first air-liquid heat exchanger 100_{A} is mounted to the server rack 10 so that heated air expelled from the server rack 10 by the one or more fans 12 flows through the first air-liquid heat exchanger 100_{A}. The first air-liquid heat exchanger 100_{A} comprises a first frame 102_{A}, a first liquid inlet 106_{A} mounted to the first frame 102_{A} for receiving liquid from a cold supply line, a first liquid outlet 108_{A} mounted to the first frame 102 for returning liquid to a hot return line, and a first continuous internal conduit 104_{A}. The first continuous internal conduit 104_{A} forms a first plurality of interconnected parallel sections 110_{A} (only some are shown) extending within the first frame 102_{A}. Examples of the cold supply line and of the hot return line are shown on later Figures.

The first continuous internal conduit 104_{A} connects the first liquid inlet 106_{A} to the first liquid outlet 108_{A}. In more details, a first one of the first plurality of interconnected parallel sections 110_{A} is connected to the first liquid inlet 106_{A}. Then, each one of the first plurality of interconnected parallel sections 110_{A} except a last one is connected to a next one of the first plurality of interconnected parallel sections 110_{A} via one of a first plurality of U-shaped sections 112_{A} of the first continuous internal conduit 104_{A}. The last one of the first plurality of interconnected parallel sections 110_{A} is connected to the first liquid outlet 108_{A}.

The second air-liquid heat exchanger 100_{B} is mounted to the first air-liquid heat exchanger 100_{A} so that air having flowed through the first air-liquid heat exchanger 100_{A} flows through the second air-liquid heat exchanger 100_{B}. The second air-liquid heat exchanger 100_{B} comprises a second frame 102_{B}, a second liquid inlet 106_{B} mounted to the second frame 102_{B} and adapted to receive liquid from the same cold supply line or from another cold supply line, a second liquid outlet 108_{B} mounted to the second frame 102_{B} and adapted to return liquid to the same hot return line or to another hot return line, and a second continuous internal conduit 104_{B} forming a second plurality of interconnected parallel sections 110_{B} (only some are shown) extending within the second frame 102_{B}.

The second continuous internal conduit 104_{B} connects the second liquid inlet 106_{B} to the second liquid outlet 108_{B}. In more details, a first one of the second plurality of interconnected parallel sections 110_{B} is connected to the second liquid inlet 106_{B}. Then, each one of the second plurality of interconnected parallel sections 110_{B} except a last one is connected to a next one of the second plurality of interconnected parallel sections 110_{B} via one of a second plurality of U-shaped sections 112_{B} of the second continuous internal conduit 104_{B}. The last one of the second plurality of interconnected parallel sections 110_{B} is connected to the second liquid outlet 108_{B}. The first and second air-liquid heat exchangers (100_{A}, 100_{B}) are assembled in an anti-parallel configuration in the sense that liquid flows in opposite directions in their respective liquid parallel sections (110A, 110B).

Figure 6 illustrates a particular configuration in which the liquid inlet 106_{A} and the liquid outlet 108_{A} are connected on opposite sides of the frame 102_{A}, the first continuous internal conduit 104_{A} forming an even number of interconnected parallel sections 110_{A} while the second continuous internal conduit 104_{B} forms an even number of interconnected parallel sections 110_{B}. Likewise, the liquid inlet 106_{B} and the liquid outlet 108_{B} are connected on opposite sides of the frame 102_{B}. As illustrated, the interconnected parallel sections 110_{A} and 110_{B} extend horizontally. This is just one of many possible configurations. For instance, the interconnected parallel sections 110_{A} and 110_{B} may extend vertically. Some other configurations will be illustrated hereinbelow.

The first and second air-liquid heat exchangers 100_{A} and 100_{B} are mounted to the server rack 10 so that the first frame 102_{A} is parallel and adjacent to the second frame 102_{B}. One of the first plurality of interconnected parallel sections 110_{A} of the first continuous internal conduit 104_{A} nearest to the first liquid inlet 106_{A} is proximate one of the second plurality of interconnected parallel sections 110_{B} of the second continuous internal conduit 104_{B} nearest to the second liquid outlet 108_{B}. Otherwise stated, among the first plurality of interconnected parallel sections 110_{A}, the one interconnected parallel section 110_{A} that is closest to the first liquid inlet 106_{A} is also the one interconnected parallel section 110_{A} that is closest to the one interconnected parallel section 110_{B} that is closest to the second liquid outlet 108_{B}.

The one of the first plurality of interconnected parallel sections 110_{A} of the first continuous internal conduit 104_{A} nearest to the first liquid inlet 106_{A} and the one of the second plurality of interconnected parallel sections 110_{B} of the second continuous internal conduit 104_{B} nearest to the second liquid outlet 108_{B} may be directly facing each other when viewed in a general direction of an airflow expelled from the server rack 10. Alternatively, one of these first parallel sections 110_{A} or 110_{B} may be positioned slightly higher or lower than the other. Precise placement of the one of the first plurality of interconnected parallel sections 110_{A} of the first continuous internal conduit 104_{A} nearest to the first liquid inlet 106_{A} in relation to the proximate one of the second plurality of interconnected parallel sections 110_{B} of the second continuous internal conduit 104_{B} nearest to the second liquid outlet 108_{B} may depend on the construction of the first and second air-liquid heat exchangers 100_{A} and 100_{B} and on manufacturing tolerances. Minor variations on the placement of the parallel sections 110_{A} and 110_{B} within the cooling arrangement 300 are not expected to have a significant impact on the cooling performance.

Given any one of these configurations, a topmost strata of the airflow expelled from the server rack 10 flows within the first air-liquid heat exchanger 100_{A} around its topmost interconnected parallel sections 110_{A} in which the liquid flowing through the continuous internal conduit 104_{A} is coolest, being closest to the first liquid inlet 106_{A}. The topmost strata of the airflow then flows within the second air-liquid heat exchanger 100_{B} around its topmost interconnected parallel sections 110_{B} in which the liquid flowing through the continuous internal conduit 104_{B} is warmest, being closest to the second liquid outlet 108_{B}. Conversely, a bottommost strata of the airflow expelled from the server rack 10 flows within the first air-liquid heat exchanger 100_{A} around its bottommost interconnected parallel sections 110_{A} in which the liquid flowing through the continuous internal conduit 104_{A} is warmest, being closest to the first liquid outlet 108_{A}. The bottommost strata of the airflow then flows within the second air-liquid heat exchanger 100_{B} around its bottommost interconnected parallel sections 110_{B} in which the liquid flowing through the continuous internal conduit 104_{B} is coolest, being closest to the second liquid inlet 106_{B}. An equivalent result may be obtained by positioning the first liquid inlet 106_{A} and the second liquid outlet 108_{B} at the bottom of the cooling arrangement 300, also positioning the first liquid outlet 108_{A} and the second liquid inlet 106_{B} at the top of the cooling arrangement 300. Rotating the cooling arrangement 300 so that the interconnected parallel sections 110_{A} and 110_{B} extend vertically is also contemplated.

This effect is spread to all strata of the airflow, each of which gradually receive less cooling from the first air-liquid heat exchanger 100_{A} along their distribution from the topmost strata toward the bottommost strata, gradually receiving more cooling from the second air-liquid heat exchanger 100_{B} along the same distribution.

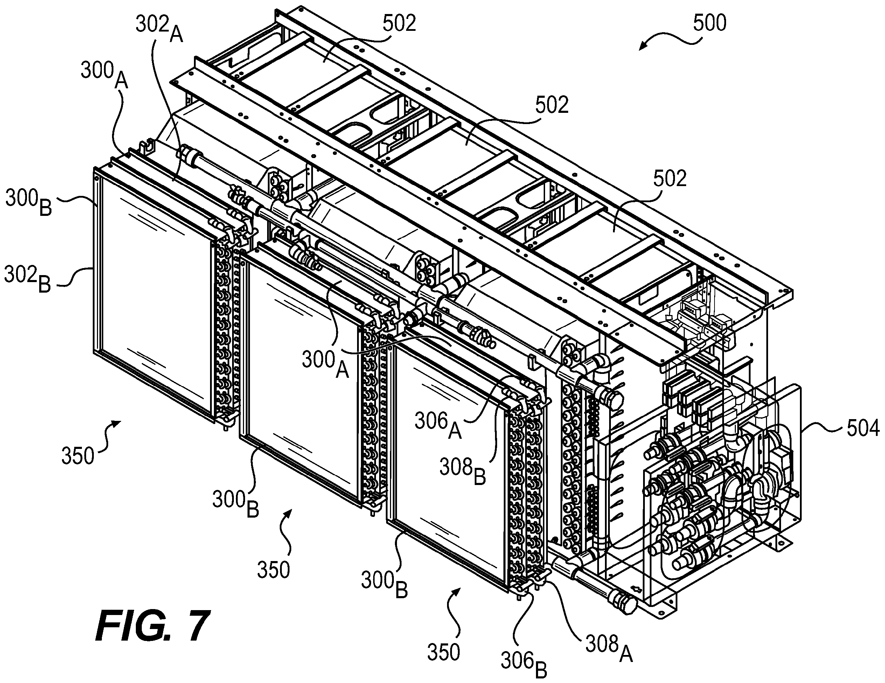

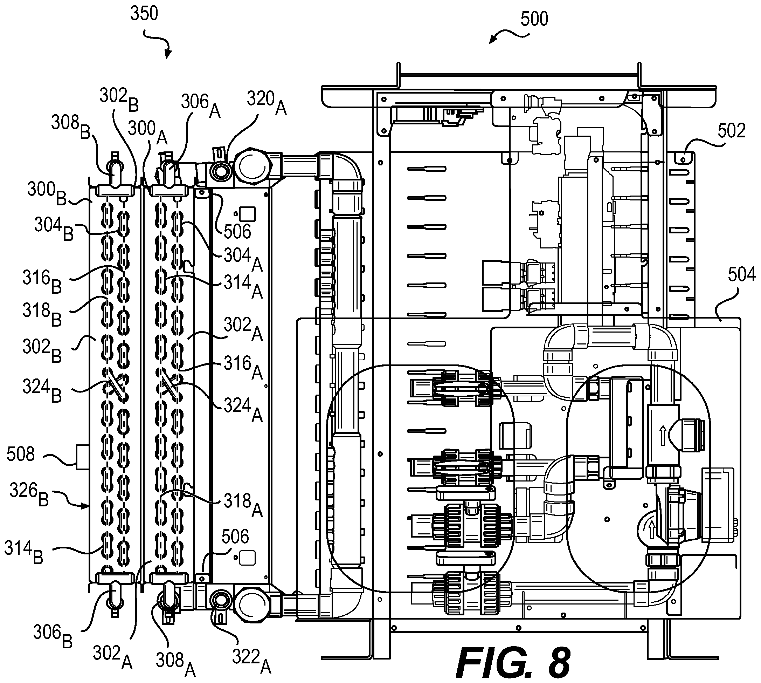

Figure 7 is a perspective view of a server rack on which pairs of dual-flow air-liquid heat exchangers are mounted in an anti-parallel configuration in accordance with an embodiment of the present technology. Figure 8 is a side elevation view of the server rack of Figure 7 in accordance with an embodiment of the present technology. A server rack 500 has a plurality of server housings 502 (three are shown), each of which includes at least one fan 12 (Figure 1). A cooling arrangement 350 is mounted on each of the server housings 502, each cooling arrangement 350 including first and second dual-flow air-liquid heat exchangers 300_{A} and 300_{B}. These dual-flow air-liquid heat exchangers 300_{A} and 300_{B} represent a modest increase in size, particularly an increased thickness, when compared to the single-flow heat exchangers 100 used in the configuration of Figure 6. They however provide a large increase in cooling efficiency while remaining significantly thinner than the multi-flow air-liquid heat exchanger 200 of Figure 4.

The fan or fans 12 contained within each server housing 502 provide forced air cooling to the equipment mounted in the server housings 502 and generate an airflow directed toward the corresponding cooling arrangements 350. Within each cooling arrangement 350, each one of the first and second dual-flow air-liquid heat exchangers 300_{A} and 300_{B} may be configured to provide sufficient redundancy of the cooling capacity, each one of the first and second dual-flow air-liquid heat exchangers 300_{A} and 300_{B} being able to reduce a temperature of the air expelled from the rack (10, 500) to less than a maximum rated air temperature to maintain a safe operating temperature of the corresponding server housing 502 on which it is mounted when the other one of the first and second dual-flow air-liquid heat exchangers 300_{A} and 300_{B} is taken out of service for maintenance or as a result from an equipment failure.

The server rack 500 may also include a secondary cooling system 504 mounted on its lateral side. The secondary cooling system 504 may include one or more of a liquid cooling system or a two-phase cooling system including waterblocks, cold plates and/or evaporators and liquid condensers (not shown) mounted on heat-generating components (not shown) within the server rack 500.

On Figures 7 and 8, a liquid inlet 306_{A} and a liquid outlet 308_{A} are connected on a same side of a frame 302_{A}, and a liquid inlet 306_{B} and a liquid outlet 308_{B} are connected on a same side of the frame 302_{B}. Additionally, the liquid inlets 306_{A} and 306_{B} are located on a same side of the cooling arrangement 350. An alternate configuration in which the liquid inlets 306_{A} and 306_{B} are located on opposite sides of the cooling arrangement 350 is also contemplated.

As best seen on Figure 8, in a particular non-limiting configuration, the first dual-flow air-liquid heat exchanger 300_{A} comprises a first continuous internal conduit 304_{A} forming a first plurality of interconnected parallel sections (not shown) and a third continuous internal conduit 314_{A} forming a third plurality of interconnected parallel sections (not shown). The first and third pluralities of interconnected parallel sections extend within the first frame 302_{A}. The first and third continuous internal conduits 304_{A} and 314_{A} connect the first liquid inlet 306_{A} to the first liquid outlet 308_{A}. Likewise, the second dual-flow air-liquid heat exchanger 300_{B} comprises a second continuous internal conduit 304_{B} forming a second plurality of interconnected parallel sections (not shown) and a fourth continuous internal conduit 314_{B} forming a fourth plurality of interconnected parallel sections (not shown), the second and fourth pluralities of interconnected parallel sections extending within the second frame 302_{B}. The second and fourth continuous internal conduits 304_{N} and 314_{B} connect the second liquid inlet 306_{B} to the second liquid outlet 308_{B}.

As illustrated, a first portion of the first plurality of interconnected parallel sections is located in a first plane 316_{A} within the first frame 302_{A} and a second portion of the first plurality of interconnected parallel sections is located in a second plane 318_{A} within the first frame 302_{A}, the second plane 318_{A} being parallel to the first plane 316_{A}. Conversely, a first portion of the third plurality of interconnected parallel sections is located in the second plane 318_{A} within the first frame 302_{A} and a second portion of the third plurality of interconnected parallel sections is located in the first plane 316_{A} within the first frame 302_{A}. The third continuous internal conduit 314_{A} and the first continuous internal conduit 304_{A}, both change between the first plane 316_{A} and the second plane 318_{A} at a crossing point 324_{A}. Variants of the first dual-flow air-liquid heat exchanger 300_{A} may include one or more crossing points 324_{A} and may alternatively have no such crossing point.

Likewise, a first portion of the second plurality of interconnected parallel sections is located in a third plane 316_{B} within the second frame 302_{B} and a second portion of the second plurality of interconnected parallel sections is located in a fourth plane 318_{B} within the second frame 302_{B}, the fourth plane 318_{B} being parallel to the third plane 316_{B}. Conversely, a first portion of the fourth plurality of interconnected parallel sections is located in the fourth plane 318_{B} within the second frame 302_{B} and a second portion of the fourth plurality of interconnected parallel sections is located in the third plane 316_{B} within the second frame 302_{B}. The fourth continuous internal conduit 314_{B} and the second continuous internal conduit 304_{B}, both change between the third plane 316_{B} and the fourth plane 318_{B} at a crossing point 324_{B}. Variants of the second dual-flow air-liquid heat exchanger 300_{B} may include one or more crossing points 324_{B} and may alternatively have no such crossing point. The first and second dual-flow air-liquid heat exchangers 300_{A}, 300_{B} of the cooling arrangement 350 may have different numbers of crossing points 324_{A} or 324_{B}.

As best seen on Figure 8, the liquid inlet 306_{A} of each cooling arrangement 350 is connected to a first cold supply line 320_{A} and the liquid outlet 308_{A} of each cooling arrangement 350 is connected to a first hot return line 322_{A}. Although not shown, the liquid inlet 306_{B} of each cooling arrangement 350 may be connected to the first cold supply line 320_{A} or to another cold supply line (not shown), and the liquid outlet 308_{B} of each cooling arrangement 350 may be connected to the first hot return line 322_{A} or to another hot return line (not shown). The first cold supply line 320_{A} and the first hot return line 322_{A}, as well as the other cold supply line and the hot return line, if present, may be also be connected to the secondary cooling system 504 for the server rack 500. A pump (not shown) provides a continuous flow of cold liquid delivered to the cooling arrangement 350 via the cold supply line or lines and retrieves heated liquid from the cooling arrangement 350 via the hot return line or lines. The pump transports the heated liquid toward further cooling equipment, for example cooling towers (not shown), located outside of the data center.

Figure 8 also shows that the cooling arrangement 350 may be mounted on the server rack 500 by use of a pair of hinges 506 mounted on a lateral side of the first frame 302_{A}, the hinges 506 being adapted for pivotally mounting the cooling arrangement 350 on the rack 10. Optionally, additional hinges may be installed between the two hinges 506 as shown. The particular configuration of Figure 8 shows that the hinges 506 are located on the same side of the cooling arrangement 350 where the liquid inlets 306_{A}, 306_{B} and the liquid outlets 308_{A}, 308_{B} are also located. This configuration facilitates pivoting of the cooling arrangement 350 about the hinges 350. Mounting the cooling arrangement 300 of Figure 6 on a rack using the hinges 506 is also contemplated.

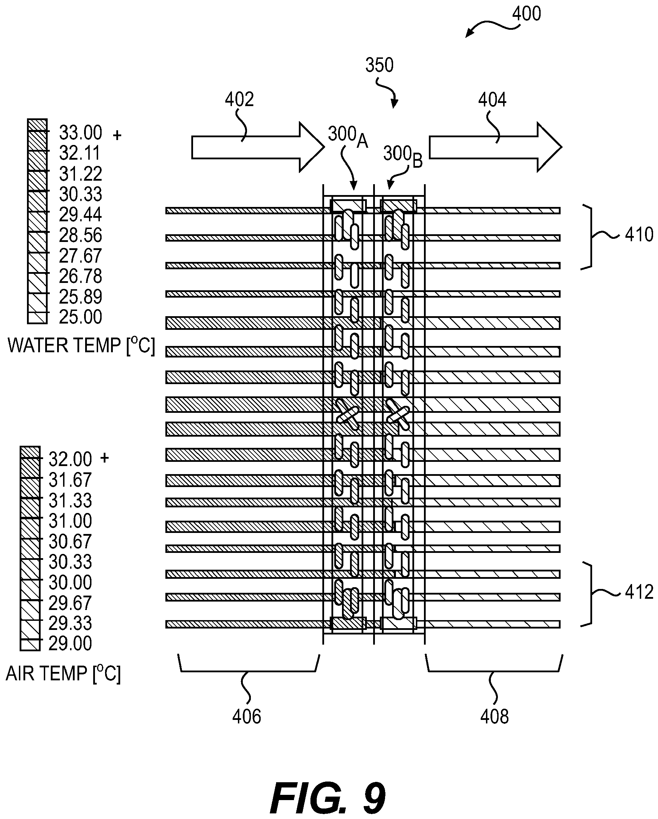

Also shown on Figure 8 is a temperature sensor 508 mounted on an external face 326_{B} of the dual-flow second air-liquid heat exchanger 300_{B}. The temperature sensor 508 may measure and transmit a temperature of air having flowed through the first and second dual-flow air-liquid heat exchangers 300_{A}, 300_{B} to a remote monitoring device (not shown). The server rack 500 may comprise a plurality of additional sensors (not shown) for providing various temperature, liquid flow, and pressure measurements to the remote monitoring device, the temperature sensor 508 and these additional sensors sharing a common communication link (not shown) for forwarding their measurements to the remote monitoring device. A position of the temperature sensor 508 on the external face 326_{B} of the second dual-flow air-liquid heat exchanger 300_{B} may vary horizontally and/or vertically, given that the temperature of the air having flowed through the first and second dual-flow air-liquid heat exchangers 300_{A}, 300_{B} substantially homogeneous, as will be illustrated on Figure 9. Mounting the temperature sensor 508 on an external face of the second air-liquid heat exchanger 100_{B} of the cooling arrangement 300 is also contemplated.

Figure 9 is a visual representation of a homogeneous temperature pattern of an airflow expelled from dual-flow air-liquid heat exchangers assembled in an anti-parallel configuration in accordance with an embodiment of the present technology. A diagram 400 illustrates a temperature of a flow of air determined in a simulation environment, before and after passing through the cooling arrangement 350. The air flows in the direction of arrows 402 and 404. In a first zone 406 upstream of the cooling arrangement 350, a temperature of the airflow is high due to the generation of heat in the server rack 10, being for example at about 40 degrees. The temperature of the airflow is substantially uniform within the first zone 406. Cold water is received at the top of the first dual-flow air-liquid heat exchanger 300_{A}, at a temperature of about 25 degrees. Upper strata 410 of the air flowing downstream of the first dual-flow air-liquid heat exchanger 300_{A} are cooled to about 30 degrees. A temperature of the water flowing through the first dual-flow air-liquid heat exchanger 300_{A} increases as it passes through the various interconnected parallel sections 110_{A}, being continuously exposed to the 40 degrees airflow. The water reaches about 33 degrees the bottom of the first dual-flow air-liquid heat exchanger 300_{A}. Consequently, the airflow between the first and second dual-flow air-liquid heat exchangers 300_{A}, 300_{B} has a stratified, heterogeneous temperature profile in which lower strata 412 of the air flowing downstream of the first dual-flow air-liquid heat exchanger 300_{A} are only cooled to about 37 degrees.

The same airflow immediately reaches the second dual-flow air-liquid heat exchanger 300_{B}. Cold water is received at the bottom of the second dual-flow air-liquid heat exchanger 300_{B}, also at a temperature of about 25 degrees. Lower strata 412 of the airflow, which have been cooled to a limited extent to about 37 degrees when flowing through the dual-flow first air-liquid heat exchanger 300_{A}, receive maximum cooling from the dual-flow second air-liquid heat exchanger 300_{B} and reach a temperature of about 30 degrees. Upper strata 410 of the airflow, which have been cooled to a larger extent to about 30 degrees when flowing through the first dual-flow air-liquid heat exchanger 300_{A}, receive a modest level of cooling from the second dual-flow air-liquid heat exchanger 300_{B} to also reach a temperature of about 29 degrees. As a result, the same airflow having passed through the second dual-flow air-liquid heat exchanger 300_{B} has a substantially homogeneous temperature profile and all strata of the airflow expelled from the cooling arrangement 350 in a zone 408 are at a substantially uniform temperature of about 30 degrees. The water also reaches about 29 degrees the top of the second dual-flow air-liquid heat exchanger 300_{B}.

Referring again to Figure 3, the diagram 150 illustrates results obtained when using the single-flow heat exchanger 100. In contrast, the diagram 400 illustrates results obtained when using a pair of dual-flow heat exchangers 300_{A}, 300_{B}. These results are not directly comparable due to the respective cooling capacities of these different heat exchangers. However, while the numerical absolute temperature values shown on Figures 3 and 9 cannot be directly compared, the difference in the airflow temperature patterns is striking: while Figure 3 shows an important stratification of the temperature pattern, Figure 9 shows uniformity and homogeneity of the temperature in all strata of the airflow expelled from the cooling arrangement 350. It may be noted that using a pair of single-flow heat exchangers mounted in anti-parallel fashion would arguably produce a lesser decrease of the airflow temperature, but would nevertheless provide homogeneity of the temperature in all strata of the resulting airflow. In contrast, using a single dual-flow heat exchanger would still result in a stratified, heterogeneous temperature profile of the resulting airflow.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It should be expressly understood that not all technical effects mentioned herein need to be enjoyed in each and every embodiment of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A cooling arrangement (300, 350) for a rack (10, 500) hosting electronic equipment and at least one fan (12), the cooling arrangement (300, 350) comprising:
a first air-liquid heat exchanger (100_{A}, 300_{A}) mounted to the rack (10, 500) so that heated air expelled from the rack (10, 500) by the at least one fan (12) flows through the first air-liquid heat exchanger (100_{A}, 300_{A}), the first air-liquid heat exchanger (100_{A}, 300_{A}) comprising a first frame (102_{A}, 302_{A}), a first liquid inlet (106_{A}, 306_{A}) mounted to the first frame (102_{A}, 302_{A}) and adapted to receive liquid from a first cold supply line (320_{A}), a first liquid outlet (108_{A}, 308_{A}) mounted to the first frame (102_{A}, 302_{A}) and adapted to return liquid to a first hot return line (322_{A}), and a first continuous internal conduit (104_{A}, 304_{A}) forming a first plurality of interconnected parallel sections (110_{A}) extending within the first frame (102_{A}, 302_{A}), the first continuous internal conduit (104_{A}, 304_{A}) connecting the first liquid inlet (106_{A}, 306_{A}) to the first liquid outlet (108_{A}, 308_{A}); and
a second air-liquid heat exchanger (100_{B}, 300_{B}) mounted to the first air-liquid heat exchanger (100_{A}, 300_{A}) so that air having flowed through the first air-liquid heat exchanger (100_{A}, 300_{A}) flows through the second air-liquid heat exchanger (100_{B}, 300_{B}), the second air-liquid heat exchanger (100_{B}, 300_{B}) comprising a second frame (102_{B}, 302_{B}), a second liquid inlet (106_{B}, 306_{B}) mounted to the second frame (102_{B}, 302_{B}) and adapted to receive liquid from the first cold supply line (320_{A}) or from a second cold supply line, a second liquid outlet (108_{B}, 308_{B}) mounted to the second frame (102_{B}, 302_{B}) and adapted to return liquid to the first hot return line (322_{A}) or to a second hot return line, and a second continuous internal conduit (104_{B}, 304_{B}) forming a second plurality of interconnected parallel sections (110_{B}) extending within the second frame (102_{B}, 302_{B}), the second continuous internal conduit (104_{B}, 304_{B}) connecting the second liquid inlet (106_{B}, 306_{B}) to the second liquid outlet (108_{B}, 308_{B});
wherein the first frame (102_{A}, 302_{A}) is parallel and adjacent to the second frame (102_{B}, 302_{B}), and one of the first plurality of interconnected parallel sections (110_{A}) of the first continuous internal conduit (104_{A}, 304_{A}) nearest to the first liquid inlet (106_{A}, 306_{A}) is proximate one of the second plurality of interconnected parallel sections (110_{B}) of the second continuous internal conduit (104_{B}, 304_{B}) nearest to the second liquid outlet (108_{B}, 308_{B});
**characterized in that**:
the first air-liquid heat exchanger (100_{A}, 300_{A}) and the second air-liquid heat exchanger (100_{B}, 300_{B}) are assembled in an anti-parallel configuration;
an airflow between the first and second air-liquid heat exchangers (100_{A}, 300_{A}, 100_{B}, 300_{B}) has a heterogeneous temperature profile; and
the same airflow having passed through the second air-liquid heat exchanger (100_{B}, 300_{B}) has a substantially homogeneous temperature profile.

2. The cooling arrangement (300, 350) of claim 1, wherein:
the first liquid inlet (106_{A}, 306_{A}) and the first liquid outlet (108_{A}, 308_{A}) are connected on a same side of the first frame (102_{A}, 302_{A}); and
the second liquid inlet (106_{B}, 306_{B}) and the second liquid outlet (108_{B}, 308_{B}) are connected on a same side of the second frame (102_{B}, 302_{B}).

3. The cooling arrangement (300, 350) of claim 1 or 2, wherein the first liquid inlet (106_{A}, 306_{A}) and the second liquid inlet (106_{B}, 306_{B}) are located on a same side of the cooling arrangement (300, 350).

4. The cooling arrangement (300, 350) of any one of claims 1 to 3, wherein the first and second pluralities of interconnected parallel sections of the first and second continuous internal conduits (104_{A}, 304_{A}, 104_{B}, 304_{B}) extend horizontally.

5. The cooling arrangement (300, 350) of any one of claims 1 to 3, wherein the first and second pluralities of interconnected parallel sections of the first and second continuous internal conduits (104_{A}, 304_{A}, 104_{B}, 304_{B}) extend vertically.

6. The cooling arrangement (300, 350) of any one of claims 1 to 5, wherein:
a first one of the first plurality of interconnected parallel sections (110_{A}) is connected to the first liquid inlet (106_{A}, 306_{A});
each one of the first plurality of interconnected parallel sections (110_{A}) except a last one of the first plurality of interconnected parallel sections (110_{A}) is connected to a next one of the first plurality of interconnected parallel sections (110_{A}) via one of a first plurality of U-shaped sections (112_{A}) of the first continuous internal conduit (104_{A}, 304_{A});
the last one of the first plurality of interconnected parallel sections (110_{A}) is connected to the first liquid outlet (108_{A}, 308_{A});
a first one of the second plurality of interconnected parallel sections (110_{B}) is connected to the second liquid inlet (106_{B}, 306_{B});
each one of the second plurality of interconnected parallel sections (110_{B}) except a last one of the second plurality of interconnected parallel sections (110_{B}) is connected to a next one of the second plurality of interconnected parallel sections (110_{B}) via one of a second plurality of U-shaped sections (112_{B}) of the second continuous internal conduit (104_{B}, 304_{B}); and
the last one of the second plurality of interconnected parallel sections (110_{B}) is connected to the second liquid outlet (108_{B}, 308_{B}).

7. The cooling arrangement (350) of any one of claims 1 to 6, wherein:
the first air-liquid heat exchanger is a first dual-flow air-liquid heat exchanger (300_{A}) further comprising a third continuous internal conduit (314_{A}) forming a third plurality of interconnected parallel sections extending within the first frame (302_{A}), the third continuous internal conduit (314_{A}) connecting the first liquid inlet (306_{A}) to the first liquid outlet (308_{A}); and
the second air-liquid heat exchanger is a second dual-flow air-liquid heat exchanger (300_{B}) further comprising a fourth continuous internal conduit (314_{B}) forming a fourth plurality of interconnected parallel sections extending within the second frame (302_{B}), the fourth continuous internal conduit (314_{B}) connecting the second liquid inlet (306_{B}) to the second liquid outlet (308_{B}).

8. The cooling arrangement (350) of claim 7, wherein:
a first portion of the first plurality of interconnected parallel sections is located in a first plane (316_{A}) within the first frame (302_{A});
a second portion of the first plurality of interconnected parallel sections is located in a second plane (318_{A}) within the first frame (302_{A}), the second plane (318_{A}) being parallel to the first plane (316_{A});
a first portion of the third plurality of interconnected parallel sections is located in the second plane (318_{A}) within the first frame (302_{A});
a second portion of the third plurality of interconnected parallel sections is located in the first plane (316_{A}) within the first frame (302_{A});
a first portion of the second plurality of interconnected parallel sections is located in a third plane (316_{B}) within the second frame (302_{B});
a second portion of the second plurality of interconnected parallel sections is located in a fourth plane (318_{B}) within the second frame (302_{B}), the fourth plane (318_{B}) being parallel to the third plane (316_{B});
a first portion of the fourth plurality of interconnected parallel sections is located in the fourth plane (318_{B}) within the second frame (302_{B}); and
a second portion of the fourth plurality of interconnected parallel sections is located in the third plane (316_{B}) within the second frame (302_{B}).

9. The cooling arrangement (300, 350) of any one of claims 1 to 8, further comprising:
the first cold supply line (320_{A}); and
the first hot return line (322_{A}).

10. The cooling arrangement (300, 350) of claim 9, wherein the first cold supply line (320_{A}) and the first hot return line (322_{A}) are connected to a secondary cooling system (504) for the rack (10, 500).

11. The cooling arrangement (300, 350) of claim 9, further comprising:
the second cold supply line; and
the second hot return line;
wherein the first cold supply line (320_{A}), the second cold supply line, the first hot return line (322_{A}) and the second hot return line are connected to a secondary cooling system (504) for the rack (10, 500).

12. The cooling arrangement (300, 350) of any one of claims 1 to 11, wherein each one of the first and second air-liquid heat exchangers (100_{A}, 300_{A}, 100_{B}, 300_{B}) is configured to reduce a temperature of the air expelled from the rack (10, 500) to less than a maximum rated air temperature when the other one of the first and second air-liquid heat exchangers (100_{A}, 300_{A}, 100_{B}, 300_{B}) is taken out of service.

13. The cooling arrangement (300, 350) of any one of claims 1 to 12, further comprising a pair of hinges (506) mounted on a lateral side of the first frame (102_{A}, 302_{A}), the hinges (506) being adapted for pivotally mounting the cooling arrangement (300, 350) on the rack (10, 500).

14. The cooling arrangement (300, 350) of any one of claims 1 to 13, further comprising a temperature sensor (508) mounted on an external face (326_{B}) of the second air-liquid heat exchanger (100_{B}, 300_{B}) and adapted to transmit a temperature of air having flowed through the first and second air-liquid heat exchangers (100_{A}, 300_{A}, 100_{B}, 300_{B}) to a remote monitoring device.

## Patentansprüche

1. Kühlanordnung (300, 350) für ein Rack (10, 500) mit elektronischer Ausrüstung und mindestens einem Gebläse (12), wobei die Kühlanordnung (300, 350) Folgendes umfasst:
einen ersten Luft-Flüssigkeit-Wärmetauscher (100_{A}, 300_{A}), der an dem Rack (10, 500) montiert ist, sodass erwärmte Luft, die aus dem Rack (10, 500) von dem mindestens einen Gebläse (12) ausgestoßen wird, durch den ersten Luft-Flüssigkeit-Wärmetauscher (100_{A}, 300_{A}) strömt, wobei der erste Luft-Flüssigkeit-Wärmetauscher (100_{A}, 300_{A}) einen ersten Rahmen (102_{A}, 302_{A}), einen ersten Flüssigkeitseinlass (106_{A}, 306_{A}), der an dem ersten Rahmen (102_{A}, 302_{A}) montiert ist und dazu ausgelegt ist, Flüssigkeit von einer ersten kalten Versorgungsleitung (320_{A}) aufzunehmen, einen ersten Flüssigkeitsauslass (108_{A}, 308_{A}), der an dem ersten Rahmen (102_{A}, 302_{A}) montiert ist und dazu ausgelegt ist, Flüssigkeit zu einer ersten heißen Rückleitung (322_{A}) zurückzuführen, und ein erstes durchgehendes inneres Rohr (104_{A}, 304_{A}), das eine erste Vielzahl von miteinander verbundenen parallelen Abschnitten (110_{A}) bildet, die sich innerhalb des ersten Rahmens (102_{A}, 302_{A}) erstreckt, umfasst, wobei das erste durchgehende innere Rohr (104_{A}, 304_{A}) den ersten Flüssigkeitseinlass (106_{A}, 306_{A}) mit dem ersten Flüssigkeitsauslass (108_{A}, 308_{A}) verbindet; und
einen zweiten Luft-Flüssigkeit-Wärmetauscher (100_{B}, 300_{B}), der an dem ersten Luft-Flüssigkeit-Wärmetauscher (100_{A}, 300_{A}) montiert ist, sodass Luft, die durch den ersten Luft-Flüssigkeit-Wärmetauscher (100_{A}, 300_{A}) geströmt ist, durch den zweiten Luft-Flüssigkeit-Wärmetauscher (100_{B}, 300_{B}) strömt,
wobei der zweite Luft-Flüssigkeit-Wärmetauscher (100_{B}, 300_{B}) einen zweiten Rahmen (102_{B}, 302_{B}), einen zweiten Flüssigkeitseinlass (106_{B}, 306_{B}), der an dem zweiten Rahmen (102_{B}, 302_{B}) montiert ist und dazu ausgelegt ist, Flüssigkeit von der ersten kalten Versorgungsleitung (320_{A}) oder von einer zweiten kalten Versorgungsleitung aufzunehmen, einen zweiten Flüssigkeitsauslass (108_{B}, 308_{B}), der an dem zweiten Rahmen (102_{B}, 302_{B}) montiert ist und dazu ausgelegt ist,
Flüssigkeit zu der ersten heißen Rückleitung (322_{A}) oder zu einer zweiten heißen Rückleitung zurückzuführen, und ein zweites durchgehendes inneres Rohr (104_{B}, 304_{B}), das eine zweite Vielzahl von miteinander verbundenen parallelen Abschnitten (110_{B}) bildet, die sich innerhalb des zweiten Rahmens (102_{B}, 302_{B}) erstreckt, umfasst, wobei das zweite durchgehende innere Rohr (104_{B}, 304_{B}) den zweiten Flüssigkeitseinlass (106_{B}, 306_{B}) mit dem zweiten Flüssigkeitsauslass (108_{B}, 308_{B}) verbindet;
wobei sich der erste Rahmen (102_{A}, 302_{A}) parallel und benachbart zu dem zweiten Rahmen (102_{B}, 302_{B}) befindet und sich einer von der ersten Vielzahl von miteinander verbundenen parallelen Abschnitten (110_{A}) des ersten durchgehenden inneren Rohres (104_{A}, 304_{A}) am nächsten zu dem ersten Flüssigkeitseinlass (106_{A}, 306_{A}) in der Nähe von einem von der zweiten Vielzahl von miteinander verbundenen parallelen Abschnitten (110_{B}) des zweiten durchgehenden inneren Rohres (104_{B}, 304_{B}) am nächsten zu dem zweiten Flüssigkeitsauslass (108_{B}, 308_{B}) befindet;
**dadurch gekennzeichnet, dass**:
der erste Luft-Flüssigkeit-Wärmetauscher (100_{A}, 300_{A}) und der zweite Luft-Flüssigkeit-Wärmetauscher (100_{B}, 300_{B}) sich in einer antiparallelen Konfiguration befinden;
ein Luftstrom zwischen dem ersten und dem zweiten Luft-Flüssigkeit-Wärmetauscher (100_{A}, 300_{A}, 100_{B}, 300_{B}) ein heterogenes Temperaturprofil aufweist; und
derselbe Luftstrom, der den zweiten Luft-Flüssigkeit-Wärmetauscher (100_{B}, 300_{B}) durchquert hat, ein im Wesentlichen homogenes Temperaturprofil aufweist.

2. Kühlanordnung (300, 350) nach Anspruch 1, wobei:
der erste Flüssigkeitseinlass (106_{A}, 306_{A}) und der erste Flüssigkeitsauslass (108_{A}, 308_{A}) auf einer gleichen Seite des ersten Rahmens (102_{A}, 302_{A}) verbunden sind; und
der zweite Flüssigkeitseinlass (106_{B}, 306_{B}) und der zweite Flüssigkeitsauslass (108_{B}, 308_{B}) auf einer gleichen Seite des zweiten Rahmens (102_{B}, 302_{B}) verbunden sind.

3. Kühlanordnung (300, 350) nach Anspruch 1 oder 2, wobei sich der erste Flüssigkeitseinlass (106_{A}, 306_{A}) und der zweite Flüssigkeitseinlass (106_{B}, 306_{B}) auf einer gleichen Seite der Kühlanordnung (300, 350) befinden.

4. Kühlanordnung (300, 350) nach einem der Ansprüche 1 bis 3, wobei sich die erste und zweite Vielzahl von miteinander verbundenen parallelen Abschnitten des ersten und zweiten durchgehenden inneren Rohres (104_{A}, 304_{A}, 104_{B}, 304_{B}) horizontal erstrecken.

5. Kühlanordnung (300, 350) nach einem der Ansprüche 1 bis 3, wobei sich die erste und zweite Vielzahl von miteinander verbundenen parallelen Abschnitten des ersten und zweiten durchgehenden inneren Rohres (104_{A}, 304_{A}, 104_{B}, 304_{B}) vertikal erstrecken.

6. Kühlanordnung (300, 350) nach einem der Ansprüche 1 bis 5, wobei:
ein erster der ersten Vielzahl von miteinander verbundenen parallelen Abschnitten (110_{A}) mit dem ersten Flüssigkeitseinlass (106_{A}, 306_{A}) verbunden ist;
jeder der ersten Vielzahl von miteinander verbundenen parallelen Abschnitten (110_{A}) abgesehen von einem letzten der ersten Vielzahl von miteinander verbundenen parallelen Abschnitten (110_{A}) mit einem nächsten der ersten Vielzahl von miteinander verbundenen parallelen Abschnitten (110_{A}) über einen einer ersten Vielzahl von U-förmigen Abschnitten (112_{A}) des ersten durchgehenden inneren Rohres (104_{A}, 304_{A}) verbunden ist;
der letzte der ersten Vielzahl von miteinander verbundenen parallelen Abschnitten (110_{A}) mit dem ersten Flüssigkeitsauslass (108_{A}, 308_{A}) verbunden ist;
ein erster der zweiten Vielzahl von miteinander verbundenen parallelen Abschnitten (110_{B}) mit dem zweiten Flüssigkeitsauslass (106_{B}, 306_{B}) verbunden ist;
jeder der zweiten Vielzahl von miteinander verbundenen parallelen Abschnitten (110_{B}) abgesehen von einem letzten der zweiten Vielzahl von miteinander verbundenen parallelen Abschnitten (110_{B}) mit einem nächsten der zweiten Vielzahl von miteinander verbundenen parallelen Abschnitten (110_{B}) über einen einer zweiten Vielzahl von U-förmigen Abschnitten (112_{B}) des zweiten durchgehenden inneren Rohres (104_{B}, 304_{B}) verbunden ist; und
der letzte der zweiten Vielzahl von miteinander verbundenen parallelen Abschnitten (110_{B}) mit dem zweiten Flüssigkeitsauslass (108_{B}, 308_{B}) verbunden ist.

7. Kühlanordnung (350) nach einem der Ansprüche 1 bis 6, wobei:
der erste Luft-Flüssigkeit-Wärmetauscher ein erster Zweistrom-Luft-Flüssigkeit-Wärmetauscher (300_{A}) ist, der ferner ein drittes durchgehendes inneres Rohr (314_{A}) umfasst, das eine dritte Vielzahl von miteinander verbundenen parallelen Abschnitten bildet, die sich innerhalb des ersten Rahmens (302_{A}) erstreckt, wobei das dritte durchgehende innere Rohr (314_{A}) den ersten Flüssigkeitseinlass (306_{A}) mit dem ersten Flüssigkeitsauslass (308_{A}) verbindet; und
der zweite Luft-Flüssigkeit-Wärmetauscher ein zweiter Zweistrom-Luft-Flüssigkeit-Wärmetauscher (300_{B}) ist, der ferner ein viertes durchgehendes inneres Rohr (314_{B}) umfasst, das eine vierte Vielzahl von miteinander verbundenen parallelen Abschnitten bildet, die sich innerhalb des zweiten Rahmens (302_{B}) erstreckt, wobei das vierte durchgehende innere Rohr (314_{B}) den zweiten Flüssigkeitseinlass (306_{B}) mit dem zweiten Flüssigkeitsauslass (308_{B}) verbindet.

8. Kühlanordnung (350) nach Anspruch 7, wobei:
sich ein erster Teil der ersten Vielzahl von miteinander verbundenen parallelen Abschnitten in einer ersten Ebene (316_{A}) innerhalb des ersten Rahmens (302_{A}) befindet;
sich ein zweiter Teil der ersten Vielzahl von miteinander verbundenen parallelen Abschnitten in einer zweiten Ebene (318_{A}) innerhalb des ersten Rahmens (302_{A}) befindet, wobei die zweite Ebene (318_{A}) parallel zur ersten Ebene (316_{A}) ist;
sich ein erster Teil der dritten Vielzahl von miteinander verbundenen parallelen Abschnitten in der zweiten Ebene (318_{A}) innerhalb des ersten Rahmens (302_{A}) befindet;
sich ein zweiter Teil der dritten Vielzahl von miteinander verbundenen parallelen Abschnitten in der ersten Ebene (316_{A}) innerhalb des ersten Rahmens (302_{A}) befindet;
sich ein erster Teil der zweiten Vielzahl von miteinander verbundenen parallelen Abschnitten in einer dritten Ebene (316_{B}) innerhalb des zweiten Rahmens (302_{B}) befindet;
sich ein zweiter Teil der zweiten Vielzahl von miteinander verbundenen parallelen Abschnitten in einer vierten Ebene (318_{B}) innerhalb des zweiten Rahmens (302_{B}) befindet, wobei die vierte Ebene (318_{B}) parallel zur dritten Ebene (316_{B}) ist;
sich ein erster Teil der vierten Vielzahl von miteinander verbundenen parallelen Abschnitten in der vierten Ebene (318_{B}) innerhalb des zweiten Rahmens (302_{B}) befindet; und
sich ein zweiter Teil der vierten Vielzahl von miteinander verbundenen parallelen Abschnitten in der dritten Ebene (316_{B}) innerhalb des zweiten Rahmens (302_{B}) befindet.

9. Kühlanordnung (300, 350) nach einem der Ansprüche 1 bis 8, ferner umfassend:
die erste kalte Versorgungsleitung (320_{A}); und
die erste heiße Rückleitung (322_{A}).

10. Kühlanordnung (300, 350) nach Anspruch 9, wobei die erste kalte Versorgungsleitung (320_{A}) und die erste heiße Rückleitung (322_{A}) mit einem sekundären Kühlsystem (504) für das Rack (10, 500) verbunden sind.

11. Kühlanordnung (300, 350) nach Anspruch 9, ferner umfassend:
die zweite kalte Versorgungsleitung; und
die zweite heiße Rückleitung;
wobei die erste kalte Versorgungsleitung (320_{A}), die zweite kalte Versorgungsleitung, die erste heiße Rückleitung (322_{A}) und
die zweite heiße Rückleitung mit einem sekundären Kühlsystem (504) für das Rack (10, 500) verbunden sind.

12. Kühlanordnung (300, 350) nach einem der Ansprüche 1 bis 11, wobei jeder des ersten und zweiten Luft-Flüssigkeit-Wärmetauschers (100_{A}, 300_{A}, 100_{B}, 300_{B}) dazu konfiguriert ist, eine Temperatur der Luft, die von dem Rack (10, 500) ausgestoßen wird, auf unterhalb einer maximalen Nennlufttemperatur zu reduzieren, wenn der andere des ersten und zweiten Luft-Flüssigkeit-Wärmetauschers (100_{A}, 300_{A}, 100_{B}, 300_{B}) außer Betrieb genommen wird.

13. Kühlanordnung (300, 350) nach einem der Ansprüche 1 bis 12, ferner umfassend ein Paar Scharniere (506), das an einer Querseite des ersten Rahmens (102_{A}, 302_{A}) montiert ist, wobei die Scharniere (506) dazu ausgelegt sind, die Kühlanordnung (300, 350) schwenkbar am Rack (10, 500) zu montieren.

14. Kühlanordnung (300, 350) nach einem der Ansprüche 1 bis 13, ferner umfassend einen Temperatursensor (508), der an einer Außenfläche (326_{B}) des zweiten Luft-Flüssigkeit-Wärmetauschers (100_{B}, 300_{B}) montiert ist und dazu ausgelegt ist, eine Temperatur von Luft, die durch den ersten und zweiten Luft-Flüssigkeit-Wärmetauscher (100_{A}, 300_{A}, 100_{B}, 300_{B}) geströmt ist, an eine Fernüberwachungsvorrichtung zu übertragen.

## Revendications

1. Agencement de refroidissement (300, 350) pour une baie (10, 500) hébergeant un équipement électronique et au moins un ventilateur (12), l'agencement de refroidissement (300, 350) comprenant :
un premier échangeur de chaleur air-liquide (100_{A}, 300_{A}) monté sur la baie (10, 500) de sorte que l'air chauffé expulsé provenant de la baie (10, 500) par l'au moins un ventilateur (12) traverse le premier échangeur de chaleur air-liquide (100_{A}, 300_{A}), le premier échangeur de chaleur air-liquide (100_{A}, 300_{A}) comprenant un premier châssis (102_{A}, 302_{A}), une première entrée de liquide (106_{A}, 306_{A}) montée sur le premier châssis (102_{A}, 302_{A}) et conçue pour recevoir le liquide provenant d'une première conduite d'alimentation froide (320_{A}), une première sortie de liquide (108_{A}, 308_{A}) montée sur le premier châssis (102_{A}, 302_{A}) et conçue pour renvoyer le liquide vers une première conduite de retour chaude (322_{A}), et un premier conduit interne continu (104_{A}, 304_{A}) formant une première pluralité de sections parallèles interconnectées (110_{A}) s'étendant à l'intérieur du premier châssis (102_{A}, 302_{A}), le premier conduit interne continu (104_{A}, 304_{A}) reliant la première entrée de liquide (106_{A}, 306_{A}) à la première sortie de liquide (108_{A}, 308_{A}) ; et
un second échangeur de chaleur air-liquide (100_{B}, 300_{B}) monté sur le premier échangeur de chaleur air-liquide (100_{A}, 300_{A}) de sorte que l'air ayant traversé le premier échangeur de chaleur air-liquide (100_{A}, 300_{A}) traverse le second échangeur de chaleur air-liquide (100_{B}, 300_{B}), le second échangeur de chaleur air-liquide (100_{B}, 300_{B}) comprenant un second châssis (102_{B}, 302_{B}),
une seconde entrée de liquide (106_{B}, 306_{B}) montée sur le second châssis (102_{B}, 302_{B}) et conçue pour recevoir le liquide provenant de la première conduite d'alimentation froide (320_{A}) ou d'une seconde conduite d'alimentation froide, une seconde sortie de liquide (108_{B}, 308_{B}) montée sur le second châssis (102_{B}, 302_{B}) et conçue pour renvoyer le liquide vers la première conduite de retour chaude (322_{A}) ou vers une seconde conduite de retour chaude, et un deuxième conduit interne continu (104_{B}, 304_{B}) formant une deuxième pluralité de sections parallèles interconnectées (110_{B}) s'étendant à l'intérieur du second châssis (102_{B}, 302_{B}), le deuxième conduit interne continu (104_{B}, 304_{B}) reliant la seconde entrée de liquide (106_{B}, 306_{B}) à la seconde sortie de liquide (108_{B}, 308_{B}) ;
dans lequel le premier châssis (102_{A}, 302_{A}) est parallèle et
adjacent au second châssis (102_{B}, 302_{B}), et l'une parmi la première pluralité de sections parallèles interconnectées (110_{A}) du premier conduit interne continu (104_{A}, 304_{A}) le plus proche de la première entrée de liquide (106_{A}, 306_{A}) est proche de l'une parmi la deuxième pluralité de sections parallèles interconnectées (110_{B}) du deuxième conduit interne continu (104_{B}, 304_{B}) le plus proche de la seconde sortie de liquide (108_{B}, 308_{B}) ;
**caractérisé en ce que** :
le premier échangeur de chaleur air-liquide (100_{A}, 300_{A}) et le second échangeur de chaleur air-liquide (100_{B}, 300_{B}) sont assemblés dans une configuration anti-parallèle ;
un flux d'air entre les premier et second échangeurs de chaleur air-liquide (100_{A}, 300_{A}, 100_{B}, 300_{B}) présente un profil de température hétérogène ; et
le même flux d'air ayant traversé le second échangeur de chaleur air-liquide (100_{B}, 300_{B}) présente un profil de température sensiblement homogène.

2. Agencement de refroidissement (300, 350) selon la revendication 1, dans lequel :
la première entrée de liquide (106_{A}, 306_{A}) et la première sortie de liquide (108_{A}, 308_{A}) sont reliées sur un même côté du premier châssis (102_{A}, 302_{A}) ; et
la seconde entrée de liquide (106_{B}, 306_{B}) et la seconde sortie de liquide (108_{B}, 308_{B}) sont reliées sur un même côté du second châssis (102_{B}, 302_{B}) .

3. Agencement de refroidissement (300, 350) selon la revendication 1 ou 2, dans lequel la première entrée de liquide (106_{A}, 306_{A}) et la seconde entrée de liquide (106_{B}, 306_{B}) sont situées sur un même côté de l'agencement de refroidissement (300, 350).

4. Agencement de refroidissement (300, 350) selon l'une quelconque des revendications 1 à 3, dans lequel les première et deuxième pluralités de sections parallèles interconnectées des premier et deuxième conduits internes continus (104_{A}, 304_{A}, 104_{B}, 304_{B}) s'étendent horizontalement.

5. Agencement de refroidissement (300, 350) selon l'une quelconque des revendications 1 à 3, dans lequel les première et deuxième pluralités de sections parallèles interconnectées des premier et deuxième conduits internes continus (104_{A}, 304_{A}, 104_{B}, 304_{B}) s'étendent verticalement.

6. Agencement de refroidissement (300, 350) selon l'une quelconque des revendications 1 à 5, dans lequel :
une première section parmi la première pluralité de sections parallèles interconnectées (110_{A}) est reliée à la première entrée de liquide (106_{A}, 306_{A}) ;
chaque section parmi la première pluralité de sections parallèles interconnectées (110_{A}), à l'exception d'une dernière section parmi la première pluralité de sections parallèles interconnectées (110_{A}), est reliée à une section suivante parmi la première pluralité de sections parallèles interconnectées (110_{A}) par l'intermédiaire d'une section parmi une première pluralité de sections en forme de U (112_{A}) du premier conduit interne continu (104_{A}, 304_{A}) ;
la dernière section parmi la première pluralité de sections parallèles interconnectées (110_{A}) est reliée à la première sortie de liquide (108_{A}, 308_{A}) ;
une première section parmi la deuxième pluralité de sections parallèles interconnectées (110_{B}) est reliée à la seconde entrée de liquide (106_{B}, 306_{B}) ;
chaque section parmi la deuxième pluralité de sections parallèles interconnectées (110_{B}), à l'exception d'une dernière section parmi la deuxième pluralité de sections parallèles interconnectées (110_{B}), est reliée à une section suivante parmi la deuxième pluralité de sections parallèles interconnectées (110_{B}) par l'intermédiaire d'une section parmi une deuxième pluralité de sections en forme de U (112_{B}) du deuxième conduit interne continu (104_{B}, 304_{B}) ; et
la dernière section parmi la deuxième pluralité de sections parallèles interconnectées (110_{B}) est reliée à la seconde sortie de liquide (108_{B}, 308_{B}) .

7. Agencement de refroidissement (350) selon l'une quelconque des revendications 1 à 6, dans lequel :
le premier échangeur de chaleur air-liquide est un premier échangeur de chaleur air-liquide (300_{A}) à double flux comprenant en outre un troisième conduit interne continu (314_{A}) formant une troisième pluralité de sections parallèles interconnectées s'étendant à l'intérieur du premier châssis (302_{A}), le troisième conduit interne continu (314_{A}) reliant la première entrée de liquide (306_{A}) à la première sortie de liquide (308_{A}) ; et
le second échangeur de chaleur air-liquide est un second échangeur de chaleur air-liquide (300_{B}) à double flux comprenant en outre un quatrième conduit interne continu (314_{B}) formant une quatrième pluralité de sections parallèles interconnectées s'étendant à l'intérieur du second châssis (302_{B}), le quatrième conduit interne continu (314_{B}) reliant la seconde entrée de liquide (306_{B}) à la seconde sortie de liquide (308_{B}).

8. Agencement de refroidissement (350) selon la revendication 7, dans lequel :
une première partie de la première pluralité de sections parallèles interconnectées est située dans un premier plan (316_{A}) à l'intérieur du premier châssis (302_{A}) ;
une seconde partie de la première pluralité de sections parallèles interconnectées est située dans un deuxième plan (318_{A}) à l'intérieur du premier châssis (302_{A}), le deuxième plan (318_{A}) étant parallèle au premier plan (316_{A}) ;
une première partie de la troisième pluralité de sections parallèles interconnectées est située dans le deuxième plan (318_{A}) à l'intérieur du premier châssis (302_{A}) ;
une seconde partie de la troisième pluralité de sections parallèles interconnectées est située dans le premier plan (316_{A}) à l'intérieur du premier châssis (302_{A}) ;
une première partie de la deuxième pluralité de sections parallèles interconnectées est située dans un troisième plan (316_{B}) à l'intérieur du second châssis (302_{B}) ;
une seconde partie de la deuxième pluralité de sections parallèles interconnectées est située dans un quatrième plan (318_{B}) à l'intérieur du second châssis (302_{B}), le quatrième plan (318_{B}) étant parallèle au troisième plan (316_{B}) ;
une première partie de la quatrième pluralité de sections parallèles interconnectées est située dans le quatrième plan (318_{B}) à l'intérieur du second châssis (302_{B}) ; et
une seconde partie de la quatrième pluralité de sections parallèles interconnectées est située dans le troisième plan (316_{B}) à l'intérieur du second châssis (302_{B}) .

9. Agencement de refroidissement (300, 350) selon l'une quelconque des revendications 1 à 8, comprenant en outre :
la première conduite d'alimentation froide (320_{A}) ; et
la première conduite de retour chaude (322_{A}).

10. Agencement de refroidissement (300, 350) selon la revendication 9, dans lequel la première conduite d'alimentation froide (320_{A}) et la première conduite de retour chaude (322_{A}) sont reliées à un système de refroidissement secondaire (504) pour la baie (10, 500).

11. Agencement de refroidissement (300, 350) selon la revendication 9, comprenant en outre :
la seconde conduite d'alimentation froide ; et
la seconde conduite de retour chaude ;
dans lequel la première conduite d'alimentation froide (320_{A}),
la seconde conduite d'alimentation froide, la première conduite de retour chaude (322_{A}) et la seconde conduite de retour chaude sont reliées à un système de refroidissement secondaire (504) pour la baie (10, 500).

12. Agencement de refroidissement (300, 350) selon l'une quelconque des revendications 1 à 11, dans lequel chacun parmi les premier et second échangeurs de chaleur air-liquide (100_{A}, 300_{A}, 100_{B}, 300_{B}) est conçu pour réduire une température de l'air expulsé provenant de la baie (10, 500) à une température inférieure à une température de l'air nominale maximale lorsque l'autre parmi les premier et second échangeurs de chaleur air-liquide (100_{A}, 300_{A}, 100_{B}, 300_{B}) est mis hors service.

13. Agencement de refroidissement (300, 350) selon l'une quelconque des revendications 1 à 12, comprenant en outre une paire de charnières (506) montées sur un côté latéral du premier châssis (102_{A}, 302_{A}), les charnières (506) étant conçues pour monter de manière pivotante l'agencement de refroidissement (300, 350) sur la baie (10, 500).

14. Agencement de refroidissement (300, 350) selon l'une quelconque des revendications 1 à 13, comprenant en outre un capteur de température (508) monté sur une face externe (326_{B}) du second échangeur de chaleur air-liquide (100_{B}, 300_{B}) et conçu pour transmettre une température de l'air ayant traversé les premier et second échangeurs de chaleur air-liquide (100_{A}, 300_{A}, 100_{B}, 300_{B}) vers un dispositif de surveillance à distance.
